# FASCICULE DE BREVET EUROPEEN

(11) **EP 4 350 439 B1**
(45) Date de publication et mention de la délivrance du brevet: **02.12.2026**
(21) Numéro de dépôt: 23202048.7
(22) Date de dépôt: 06.10.2023
(51) Int. Cl.: G03F 7/00, G03F 7/16, G03F 7/40, G03F 7/11, C25D 1/00

(54) **PROCÉDÉ DE FABRICATION D'UN MOULE POUR LA FORMATION DE PIÈCES MÉTALLIQUES PAR CROISSANCE MÉTALLIQUE**
VERFAHREN ZUR HERSTELLUNG EINER FORM ZUR HERSTELLUNG VON METALLBAUTEILEN DURCH METALLWACHSTUM
METHOD FOR PRODUCING A MOULD FOR FORMING METAL PARTS BY METAL GROWTH

(30) Priorité: 07.10.2022 EP 22200412
(43) Date de publication de la demande: 10.04.2024
(73) Titulaire: Richemont International S.A., 1752 Villars-sur-Glâne (CH)
(72) Inventeur: CHABART, Mickaël, 2014 Fleurier (CH); MONTINARO, Enrica, 3012 Berne (CH); METREF, Syrim Samir, 2000 Neuchâtel (CH)
(74) Mandataire: Novagraaf International SA

(56) Documents cités:
- EP-A1- 3 547 027
- EP-B1- 0 729 293
- EP-B1- 1 634 125
- WO-A1-2018/172894
- US-A1- 2019 278 182
- US-A1- 2022 035 247

## Description

### Domaine technique de l'invention

La présente invention concerne de manière générale la fabrication de moules pour former des pièces métalliques par galvanoplastie c'est à dire par croissance métallique galvanique ou autocatalytique (par électrodéposition ou bien dépose par un procédé sans courant appelé « electroless » ou dépôt autocatalytique qui crée des dépôts métalliques par réduction chimique autocatalytique de cations métalliques dans un bain liquide). De telles fabrications de moule font typiquement appel à des techniques de photolithographie UV où de la résine photosensible est d'abord déposée sur un substrat puis irradiée au travers d'un masque pour pouvoir faire ensuite une gravure sélective de cette résine afin de générer des empreintes de moulage dans la résine. La présente invention concerne aussi la formation des pièces métalliques dans les moules précités.

### État de la technique

Dans l'art antérieur de fabrication de moules par photolithographie, on connait le document EP1835339A1 qui divulgue des étapes de développement de résine déposée sur un substrat pour former des empreintes destinées à faire croître un dépôt métallique pour former des pièces métalliques de formes complexes. Une fois la résine déposée, le procédé comprend typiquement un ou plusieurs recuits (« pre-bake » et/ou « post-bake ») avant de développer la résine. Le procédé de fabrication du moule complet d'une manière générale, et ces étapes de recuit en particulier peuvent conduire à décoller en partie la résine du substrat et/ou à générer des interstices entre la résine et le substrat. Ces phénomènes peuvent ensuite conduire à des décollements de la résine structurée et/ou à des infiltrations du dépôt de métal entre la résine et le substrat et donc à des pièces métalliques non conformes. Par ailleurs, il peut être important de ne pas déposer de métal sur les parois verticales ou flancs de l'empreinte, pour ne pas générer de croissance parasite à partir des parois verticales ou des flancs. Le document EP1634125B1 divulgue un procédé pour former un moule en photolithographie. Le document US2019278182A1 divulgue une méthode de fabrication de pièces métalliques sur surface courbe. Le document EP0729293 A1 concerne un procédé pour configurer un substrat supportant un revêtement. Le document EP 3547027 A1 se rapporte à une méthode de fabrication de micromoules.

### Exposé de l'invention

Un but de la présente invention est de répondre aux inconvénients de l'art antérieur mentionnés ci-dessus et en particulier, tout d'abord, de proposer un procédé de fabrication d'un moule pour ensuite former une pièce métallique par galvanoplastie et/ou croissance métallique, qui permette d'éviter les décollements entre résine et substrat et les défauts d'infiltrations du dépôt de métal entre la résine et le substrat.

Pour cela, l'invention est définie par les revendications annexées, et l'invention concerne un procédé de fabrication d'un moule pour former une pièce métallique par galvanoplastie et/ou croissance métallique (par exemple un dépôt par électrodéposition ou un dépôt autocatalytique autrement appelé dépôt « electroless »), comprenant les étapes consistant à :
a- se munir d'un substrat présentant une surface de base et de préférence une surface conductrice de base,
b- former au moins une couche d'accroche sur la surface de base, de préférence sur la surface conductrice de base s'il y en a une,
c- déposer au moins une couche de résine photosensible sur la couche d'accroche, par exemple dépose de résine photosensible liquide ou visqueuse à la tournette ou dépose d'une couche de résine photosensible sous forme de résine solide (un film sec ou une feuille sèche de résine, à laminer),
d- irradier la couche de résine photosensible au travers d'un masque,
e- développer la couche de résine photosensible de sorte à creuser des cavités dans la couche de résine photosensible pour définir une empreinte de moulage.

Le procédé selon la mise en œuvre ci-dessus comprend une étape b- de formation d'une couche d'accroche sur la surface de base normalement destinée à recevoir directement la couche de résine photosensible. Une telle couche d'accroche permet d'améliorer l'adhésion de la résine photosensible, même après solidification et les différents recuits. En conséquence, la formation spécifique de cette couche d'accroche permet de limiter / supprimer les risques ultérieurs susmentionnés de décollement de la résine et/ou d'infiltration de métal entre substrat et résine photosensible. La couche d'accroche est donc une couche d'accroche de résine et on peut prévoir de former la couche d'accroche juste avant ou immédiatement avant de faire la dépose de la couche de résine épaisse destinée à former le moule.

Selon un mode de réalisation non couvert par l'invention revendiquée, l'étape b- de formation de la couche d'accroche peut comprendre les étapes consistant à :
b10- déposer une couche d'accroche en résine photosensible présentant une épaisseur de moins de 50 µm et de préférence de moins de 20 µm,
b11- chauffer la couche d'accroche en résine photosensible à une température d'au moins 120°C et de moins de 300°C, et de préférence à une température comprise entre 140°C et 220°C. Selon ce mode de réalisation, la formation d'une fine couche de résine photosensible, puis son recuit entre 120°C et 300°C permet de garantir une couche solidement accrochée sur le substrat et propice à fortement adhérer avec la résine ultérieurement déposée. La fine couche d'accroche subit peu de contraintes internes en raison de sa faible épaisseur, ce qui favorise sa bonne adhérence à la surface de base du substrat.

Selon un mode de réalisation non couvert par l'invention revendiquée, l'étape b10- peut être une étape de dépose d'une couche d'accroche en résine photosensible présentant une épaisseur de moins 2 µm et de préférence de moins de 1 µm,
et l'étape e- de développement de la couche de résine photosensible peut être suivie d'une étape consistant à rendre conductrice et apte à amorcer la croissance métallique au moins une partie du fond des cavités, telle qu'une étape de traitement plasma, avec par exemple un plasma CF₄/O₂. La fine couche d'accroche subit peu de contraintes internes en raison de sa faible épaisseur, ce qui favorise sa bonne adhérence à la surface de base du substrat. Le traitement final au plasma permet de retirer / dégager toute partie résiduelle de la couche d'accroche au fond des cavités / empreintes du moule sans pour autant affecter notablement le dimensionnel du reste de la structure car l'épaisseur de la couche d'accroche à retirer est de l'ordre du micromètre.

Selon un mode de réalisation non couvert par l'invention revendiquée, l'étape b10- peut être une étape de dépose d'une couche d'accroche en résine photosensible présentant une épaisseur de moins de 50 µm et de préférence de moins de 20 µm, et l'étape b11- de chauffage de la couche d'accroche en résine photosensible à une température d'au moins 120°C, et de préférence à une température d'au moins 140°C peut être précédée par les étapes consistant à :
b101- irradier la couche d'accroche en résine photosensible au travers d'un masque,
b102- finaliser la réticulation des zones exposées avec traitement thermique effectué à une température comprise entre 60°C et 95°C,
b103- développer la couche d'accroche en résine photosensible de sorte à creuser des cavités dans la couche d'accroche en résine photosensible pour laisser libre des portions de la surface conductrice. Selon ce mode de réalisation, la formation d'une fine couche de résine photosensible d'une épaisseur de moins de 20µm, de préférence de moins de 10 µm et de préférence de plus de 2µm (irradiée, recuite entre 60°C - 95°C puis développée et recuite à au moins 120°C) permet de garantir une couche solidement accrochée sur le substrat et propice à fortement adhérer avec la résine ultérieurement déposée. La fine couche d'accroche subit peu de contraintes internes en raison de sa faible épaisseur, ce qui favorise sa bonne adhérence à la surface de base du substrat. La structure développée peut ensuite servir de support d'adhésion aux couches suivantes de résine photosensible (déposée liquide, visqueuse ou solide en film sec ou une feuille sèche de résine).

Selon un mode de réalisation non couvert par l'invention revendiquée :
- le masque utilisé à l'étape d- d'irradiation de la couche de résine photosensible, et
- le masque utilisé à l'étape b101- d'irradiation de la couche d'accroche en résine photosensible,
peuvent être agencés pour irradier les mêmes parties du moule. La structure développée de la couche d'accroche peut ensuite servir de support d'adhésion aux couches suivantes de résine photosensible (couche épaisse, déposée liquide, visqueuse ou solide en film sec ou une feuille sèche de résine) qui seront structurées pour présenter le même motif.

Selon un mode de réalisation alternatif non couvert par l'invention revendiquée :
- le masque utilisé à l'étape d- d'irradiation de la couche de résine photosensible, et
- le masque utilisé à l'étape b101- d'irradiation de la couche d'accroche en résine photosensible,
peuvent être agencés pour irradier des parties distinctes du moule et également des parties communes du moule. La structure développée de la couche d'accroche peut ensuite servir de support d'adhésion aux couches suivantes de résine photosensible (couche épaisse, déposée liquide, visqueuse ou solide en film sec ou une feuille sèche de résine) qui seront structurées pour présenter un motif différent qui se recouvre au moins partiellement de la structure de la couche d'accroche. Ainsi, la couche ultérieure épaisse prend partiellement appui sur la structure de la couche d'accroche. On peut avoir une partie de la structure de la couche d'accroche apparente en fond des cavités ou empreintes du moule. Lors de la formation de la pièce métallique, soit les structures de la couche d'accroche sont suffisamment étroites pour permettre de les recouvrir par débordement, soit les structures de la couche d'accroche sont rendues conductrices par exemple avec un dépôt physique conducteur en phase vapeur sur toute la surface en fond de cavité avant le dépôt dans le moule. Dans ce dernier cas, les structures de la couche d'accroche peuvent être déposées directement sur des plaquettes en silicium ou silicium oxydé permettant ainsi une meilleure adhésion des structures de la couche d'accroche. Un dépôt physique d'or en phase vapeur (avec une sous-couche d'accroche de chrome ou titane ou tantale...) peut être appliqué sur la surface structurée de la couche d'accroche avant ou après le dépôt de la couche épaisse de résiné qui formera le moule à proprement parler, pour rendre conductrice toute la surface de la couche fine d'accroche ou le fond des cavités ou empreintes, avant formation des pièces métalliques par galvanoplastie et/ou croissance métallique. Les structurations de la couche d'accroche permettront ainsi des points d'ancrage aux couches épaisses de résine photosensible (par exemple résine époxy du type SU-8). Les parties de la couche d'accroche visibles au fond des cavités ou des empreintes peuvent également servir à former un décor qui sera visible en contreforme sur la pièce métallique formée par croissance métallique galvanique ou autocatalytique.

Selon un mode de réalisation non couvert par l'invention revendiquée, l'invention peut se rapporter à un procédé de fabrication d'un moule pour fabriquer une pièce métallique par électrodéposition, comprenant les étapes consistant à :
a- se munir d'un substrat présentant une surface de base et de préférence exempt de surface conductrice,
b- former au moins une couche d'accroche sur la surface de base du substrat par dépose d'une couche d'accroche en résine photosensible présentant une épaisseur de moins de 50 µm et de préférence de moins de 20 µm,
b101- irradier la couche d'accroche en résine photosensible au travers d'un masque,
b102- développer la couche d'accroche en résine photosensible de sorte à creuser des cavités dans la couche d'accroche en résine photosensible pour laisser libre des portions de la surface du substrat,
c- déposer au moins une couche de résine photosensible sur la couche d'accroche,
d- irradier la couche de résine photosensible au travers d'un masque différent du masque utilisé à l'étape b101,
e- développer la couche de résine photosensible de sorte à creuser des cavités dans la couche de résine photosensible pour définir une empreinte de moulage.

Selon un mode de réalisation, le procédé de fabrication peut comprendre avant, ou après l'étape e- de développement de la couche de résine photosensible, au moins une étape consistant à rendre conductrice et apte à amorcer la croissance métallique au moins une partie du fond des cavités formées à l'étape e-, comme par exemple réaliser un dépôt conducteur pour rendre conductrices toutes les surfaces du fond des cavités. Même si le substrat ne comprend pas de surface conductrice avant dépose de la couche d'accroche, alors la formation de cette couche conductrice (avant ou après la dépose de la couche épaisse de résine qui formera les empreintes du moule) permet de former des pièces métalliques par électrodéposition.

Selon l'invention, l'étape b- de formation de la couche d'accroche peut comprendre les étapes consistant à :
b20- déposer une couche d'accroche de moins de 50 nm et de préférence de moins de 20 nm en silicium sur la couche conductrice,
et le procédé peut comprendre, de préférence après l'étape e- de développement de la couche de résine photosensible, au moins une étape consistant à rendre conductrice et apte à amorcer la croissance métallique au moins une partie du fond des cavités. La couche d'accroche n'est pas réalisée en résine mais en silicium qui adhère fortement avec de la résine photosensible, et le substrat ne présente pas forcément de couche conductrice avant formation de la couche d'accroche (autrement dit, dans ce mode de réalisation, le substrat initial peut comprendre ou peut ne pas comprendre de surface conductrice de base). Dans le cas où la pièce métallique est formée par croissance métallique galvanique, on peut prévoir une surface conductrice de base sur le substrat, la couche de silicium est suffisamment mince pour permettre une conduction électrique entre la surface conductrice de base et le fond des cavités ou des empreintes du moule. On peut prévoir de déposer sur la couche conductrice une couche d'accroche de par exemple 10 nm en silicium (par exemple entre 8 nm et 20 nm) par dépôt physique par phase vapeur (par exemple par pulvérisation cathodique de silicium, sputtering en langue anglaise). On peut prévoir de faire ce dépôt immédiatement après le dépôt de la couche conductrice (par exemple en or) également effectué par dépôt physique par phase vapeur. En particulier, on peut prévoir de faire le dépôt de la couche conductrice (par exemple en or) par dépôt physique par phase vapeur et le dépôt de la couche d'accroche en silicium par dépôt physique par phase vapeur sans rupture du vide entre ces deux dépôts.

Selon un mode de réalisation, l'étape consistant à rendre conductrice et apte à amorcer la croissance métallique au moins une partie du fond des cavités peut comprendre une gravure de la couche d'accroche en silicium, par exemple une gravure ionique réactive, ou une gravure plasma CF₄/O₂, ou une gravure plasma HF/O₂, ou une gravure plasma C₄F₈/O₂, ou une gravure chimique par voie humide par exemple avec une base comme de la soude ou de de l'hydroxyde de potassium, ou avec un acide comme de l'acide fluorhydrique. Dans ce cas, le substrat initial comprend une surface conductrice de base, est celle-ci est dégagée par la gravure de la couche d'accroche.

Selon l'invention l'étape b- de formation de la couche d'accroche peut comprendre les étapes consistant à :
b30- déposer une couche d'accroche d'oxyde métallique ou d'oxyde metalloïde,
b31- fonctionnaliser la couche d'accroche d'oxyde métallique ou d'oxyde metalloïde en déposant une couche de promotion adhésive préférentiellement organique comprenant par exemple une fonction capable de former une liaison avec la couche d'accroche d'oxyde métallique ou d'oxyde metalloïde, et plus préférentiellement comprenant une fonction silanol, phosphonate, thiol, amine, époxyde, acide carboxylique,
et le procédé peut comprendre, de préférence après l'étape e- de développement de la couche de résine photosensible, au moins une étape consistant à rendre conductrice et apte à amorcer la croissance métallique au moins une partie du fond des cavités. Des surfaces comme une couche d'accroche d'oxyde métallique ou d'oxyde metalloïde permettent une fonctionnalisation facile de leur surface avec des chimie Silanol, thiol, amine, époxyde, acide carboxylique. Des liaisons covalentes se forment entre la surface et les molécules greffées. Une des chaines de la molécule peut être choisie pour réagir chimiquement avec la résine photosensible de la couche épaisse ultérieurement déposée et former à son tour une liaison covalente. En particulier, on peut prévoir le silanol ou les phophonates pour la liaison avec les oxides, et les fonctions thiol, amine, époxyde, acide carboxylique pour la liaison avec la résine photosensible du type SU8. De manière préférée, ce mode de réalisation peut être utilisé pour réaliser un moule pour former une pièce métallique par galvanoplastie (par exemple un dépôt par électrodéposition).

Selon un mode de réalisation, l'étape b30- de dépose d'une couche d'accroche d'oxyde métallique ou d'oxyde metalloïde peut être une étape de formation d'une couche d'accroche en dioxyde de silicium SiO₂ ou en oxyde de métal, comme un oxyde de métal pauvre tel que de l'alumine Al₂O₃ ou un oxyde de métal de transition comme du dioxyde de titane TiO₂.

Selon un mode de réalisation, l'étape b30- de dépose d'une couche d'accroche d'oxyde métallique ou d'oxyde metalloïde peut comprendre :
- une étape consistant à déposer un métal ou un métalloïde par dépôt physique en phase vapeur comme de l'aluminium Al, du titane Ti, du silicium Si, et
- une étape consistant à oxyder ou à laisser s'oxyder à l'air le métal ou le métalloïde pour avoir en surface de l'oxyde métallique ou de l'oxyde metalloïde comme de l'alumine Al₂O₃, du dioxyde de titane TiO₂, du dioxyde de silicium SiO₂.

Selon un mode de réalisation, l'étape consistant à rendre conductrice et apte à amorcer la croissance métallique au moins une partie du fond des cavités peut comprendre une gravure de la couche d'accroche en oxyde métallique ou en oxyde metalloïde, par exemple une gravure plasma, ou une gravure chimique par voie humide avec de la soude ou de de l'hydroxyde de potassium, ou avec un acide comme de l'acide fluorhydrique HF ou de l'acide fluorhydrique tamponné BHF. Dans ce cas, le substrat initial comprend une surface conductrice de base, est celle-ci et dégagée par la gravure de la couche d'accroche.

Selon un mode de réalisation, l'étape consistant à rendre conductrice et apte à amorcer la croissance métallique au moins une partie du fond des cavités peut être une étape de formation d'une couche conductrice, par exemple en or, au fond des cavités par dépôt physique en phase vapeur. Dans le cas d'une fabrication de pièce métallique par croissance métallique galvanique, le substrat initial comprend une surface conductrice de base, et celle-ci peut être reliée électriquement avec une couche conductrice créée par le dépôt physique en phase vapeur, une fois la couche épaisse de résine photosensible développée, au travers de la couche d'accroche d'oxyde métallique ou d'oxyde metalloïde qui est suffisamment mince.

Selon un mode de réalisation, l'étape de formation d'une couche conductrice au fond des cavités formées à l'étape e- peut être ajustée pour :
- dépasser une limite de percolation de la couche conductrice déposée au fond des cavités formées à l'étape e-, et
- ne pas dépasser la limite de percolation de la couche conductrice déposée sur les flancs des cavités formées à l'étape e-. Selon la mise en œuvre ci-dessus, le dépôt de la couche conductrice de recouvrement est prévu pour ne rendre conductrice que la surface de base en fond d'empreinte, et non les flancs ou parois verticales. Autrement dit, un courant électrique peut passer dans la couche conductrice de recouvrement au fond des cavités car la couche conductrice de recouvrement est suffisamment épaisse, alors que le courant électrique ne peut pas passer dans la couche conductrice de recouvrement sur les flancs ou parois verticales de la résine photosensible formant les parties en relief du moule, car la couche conductrice de recouvrement est trop fine (dans le détail, les rares particules de la couche conductrice de recouvrement déposées sur les flancs ou parois verticales sont trop éloignées les unes des autres pour conduire l'électricité).

D'une manière générale, l'étape consistant à rendre conductrice au moins une partie du fond des cavités peut être remplacée par une étape consistant à procurer une capacité d'amorçage d'un dépôt autocatalytique à au moins une partie du fond des cavités. En effet, dans le cas où la croissance métallique est effectuée par électrodéposition, on peut prévoir de rendre conductrice au moins une partie du fond des cavités, mais dans le cas où la croissance métallique est effectuée par croissance métallique autocatalytique, on peut prévoir de déposer une couche qui est apte à amorcer la croissance métallique autocatalytique. On peut prévoir un dépôt physique sous forme vapeur de palladium ou de platine.

Un autre but de la présente divulgation est de proposer un moule pour former des pièces métalliques par galvanoplastie et/ou croissance métallique (galvanique ou autocatalytique), dont les empreintes garantissent une croissance homogène et complète à partir du fond seulement, c'est-à-dire sans croissances parasites à partir des flancs ou des parois verticales. Un objet de l'invention est également de proposer un procédé pour fabriquer de tels moules.

Pour cela un deuxième aspect non couvert par l'invention revendiquée concerne un moule de fabrication par électrodéposition d'une pièce d'horlogerie, comprenant :
- un substrat supportant au moins une couche de résine photosensible texturée,
- au moins une empreinte à remplir par électrodéposition pour former la pièce d'horlogerie, l'empreinte étant définie dans la couche de résine photosensible et comprenant un fond d'empreinte conducteur,
caractérisé en ce que la couche de résine photosensible comprend au moins un rebord qui s'étend au dessus d'une partie de l'empreinte. Un tel rebord, de préférence ménagé sur la surface supérieure de la résine texturée formant l'empreinte, permet de garantir que le fond d'empreinte peut être rendu conducteur par une métallisation effectuée après la formation de l'empreinte, sans déposer de métal sur les parois verticales ou flancs de l'empreinte. En effet, le rebord en question forme un écran qui empêche le dépôt de matière sur les parois verticales des empreintes. Le moule selon le deuxième aspect peut avoir été réalisé en faisant appel à un ou plusieurs modes de réalisation du premier aspect.

Selon un mode de réalisation, le moule peut comprendre une couche d'accroche agencée sous la couche de résine photosensible texturée.

Selon un mode de réalisation, le moule peut comprendre une pluralité d'empreintes ayant chacune un fond d'empreinte conducteur, les fonds d'empreinte conducteurs étant électriquement reliés entre eux.

Selon un mode de réalisation, le rebord peut former une saillie sur un flanc de l'empreinte. La saillie est de préférence agencée sur la partie supérieure des flancs de l'empreinte, et de préférence sur la surface supérieure de la résine texturée formant l'empreinte.

Selon un mode de réalisation, le rebord peut faire partie d'une surface supérieure de la couche de résine photosensible.

Selon un mode de réalisation, le rebord peut former un surplomb au dessus de l'empreinte d'une dimension de saillie comprise entre 2 µm à 20 µm, et de préférence entre 2 µm et 8µm. Autrement dit, selon une direction horizontale et/ou parallèle au fond de l'empreinte, le rebord peut présenter une dimension ou une taille comprise entre 2 µm à 20 µm, et de préférence entre 2 µm et 8µm. En d'autres termes, selon une direction normale aux flancs de l'empreinte, le rebord peut présenter une dimension ou une taille comprise entre 2 µm à 20 µm, et de préférence entre 2 µm et 8µm.

Selon un mode de réalisation, le rebord peut former un surplomb continu au dessus de l'empreinte, le long d'une périphérie de l'empreinte.

Selon un mode de réalisation, le moule peut comprendre une couche conductrice déposée sur le fond d'empreinte et sur les parties supérieures de la couche de résine photosensible.

Un troisième aspect non couvert par l'invention revendiquée se rapporte à un procédé de fabrication d'un moule pour former une pièce par électrodéposition, comprenant les étapes consistant à :
aa- se munir d'un substrat,
ab- former au moins une couche de résine photosensible sur le substrat,
ac- irradier la couche de résine photosensible au travers d'un masque,
ad- faire un premier traitement thermique à une température comprise entre 25°C et 65°C.
ae- recouvrir la couche de résine photosensible avec une couche de matériau comprenant au moins un solvant,
af- faire un deuxième traitement thermique à une température comprise entre 70°C et 95°C,
ag- développer la résine photosensible pour former au moins une empreinte laissant apparaitre le substrat et comprenant un rebord en partie supérieure,
ah- former une couche de matière au moins au fond de l'empreinte et de préférence sur les surfaces supérieures par dépôt physique en phase vapeur. Le procédé du premier aspect et le procédé du troisième aspect peuvent parfaitement être combinés et mis en œuvre pour la fabrication d'un même moule.

Selon un mode de réalisation, le procédé peut comprendre, après l'étape aa-, une étape consistant à former une couche d'accroche sur le substrat.

Selon un mode de réalisation, le procédé peut comprendre, après l'étape ag-, une étape consistant à uniformiser la ou une capacité d'amorçage du fond des cavités pour la fabrication de la pièce métallique par galvanoplastie et/ou croissance métallique

Selon un mode de réalisation, le premier traitement thermique peut être effectué pendant une durée allant de 5 min à plusieurs jours pour les plus basses températures.

Selon un mode de réalisation, le premier traitement thermique peut être effectué préférentiellement de 40 à 60°C de 30 min à 1h, de sorte à consommer une quantité contrôlée de photo-initiateur afin d'éviter la formation des rebords trop importants dans l'étape af.

Selon un mode de réalisation, le dit au moins solvant utilisé à l'étape ae peut permettre la mobilité de photo-initiateurs acides (activés par les UV) et/ou de la résine photosensible du type Su-8 (activés avec les photo-initiateur exposés aux UV). Les solvants peuvent être ceux présent dans la résine : cyclopentanone, PGMEA ; gamma-butyrolactone ... Le dit au moins solvant peut être de l'acétone et/ou un solvant permettant de dissoudre le photo initiateur activé et ou le Su-8 activé.

Selon un mode de réalisation, le deuxième traitement thermique peut être effectué pendant une durée allant de 5 min à 5h.

Selon un mode de réalisation, le dépôt physique en phase vapeur peut être directionnel. Les rebords de résine formés font alors écran (ou « parapluie ») et protègent les flancs d'un dépôt PVD. Les flancs restent ainsi non conducteurs. On peut prévoir d'ajuster l'étape de dépose pour atteindre ou juste dépasser une limite de percolation de conduite de courant électrique au fond des cavités, et pas sur les flancs ou parois verticales des parties activées, afin de ne pas perturber la croissance galvanique en cas de galvanoplastie par électrodéposition. Autrement dit, le fond des cavités est recouvert d'une couche suffisamment épaisse pour pouvoir conduire le courant électrique, alors que les flancs sont exempts de revêtement conducteur ou avec des particules conductrices trop éloignées les unes des autres pour pouvoir conduire le courant électrique. On peut prévoir d'effectuer le dépôt physique de métal sous forme vapeur de manière directionnelle, selon une direction parallèle aux flancs des cavités.

Selon un mode de réalisation, l'étape de formation d'une couche conductrice de recouvrement au fond des cavités peut être effectuée :
- sous niveau de vide inférieur à 10⁻⁴ mbar, et de préférence inférieur à 10⁻⁶ mbar,
- en plaçant par exemple une plaquette de 150 mm de côté ou de diamètre formant le substrat à au moins 500 mm de la source de matière à vaporiser et de préférence à au moins 700 mm de la source de matière à vaporiser, et/ou en chauffant la source de matière à vaporiser juste au dessus de sa température de fusion,
- en utilisant une source métallique pure à 99% au moins, comme par exemple une source d'or pur à 99% en poids.

Selon un mode de réalisation, l'étape af- peut consister à effectuer le deuxième traitement thermique après un temps prédéterminé de recouvrement de la couche de résine photosensible avec la couche de matériau comprenant au moins un solvant.

Selon un mode de réalisation, le temps prédéterminé peut être suffisant pour permettre une diffusion de catalyseurs ou d'agents réactifs dans la résine photosensible depuis une zone irradiée à l'étape ac- vers une zone non irradiée à l'étape ac-.

Selon un mode de réalisation, le temps prédéterminé peut être compris entre 1 min et 24 h.

Selon un mode de réalisation, le temps prédéterminé peut être suffisant pour permettre une diffusion de catalyseur ou d'agents réactifs sur une distance comprise allant de 2 µm à 20 µm, et de préférence allant de 2 µm à 8µm.

Selon un mode de réalisation, l'étape ae- peut consister à recouvrir la couche de résine photosensible avec une couche de matériau comprenant au moins un mélange de solvants.

Selon un mode de réalisation, on peut prévoir d'utiliser un solvant permettant de dissoudre les sels photosensibles et /ou le polymère activé et un autre solvant ne réagissant pas avec le système. Ce mélange de solvant dissout de manière contrôlée (et faiblement) les constituants pour permettre une faible migration des constituants en surface des zones exposées et former ainsi un faible rebord. On peut prévoir par exemple un solvant (pouvant dissoudre les sels photosensibles et /ou le polymère activé) choisi parmi : cyclopentanone, PGMEA, acétone ; gamma-butyrolactone ... On peut prévoir par exemple l'Isopropylalcool comme solvant ne réagissant pas.

Selon un mode de réalisation, l'étape ae- consiste à recouvrir la couche de résine photosensible avec un gel comprenant au moins un solvant.

Selon un mode de réalisation pour former un gel ou mélange visqueux de solvant, on peut par exemple prévoir de dissoudre dans un solvant (ou un mélange de solvant) un polymère ne réagissant pas avec le système, comme par exemple le polyéthylène glycol ou PEG ou encore la polyvinylpyrrolidone (PVP) ... Un mélange visqueux est plus facile à déposer et les moules après dépôt sont plus faciles à manipuler

Selon un mode de réalisation, l'étape ae- peut consister à recouvrir la couche de résine photosensible avec une résine photosensible comprenant au moins un solvant. Un solvant permettant de dissoudre les sels photosensibles et /ou le polymère activé et un autre solvant ne réagissant pas avec le système. Ce mélange de solvant dissout de manière contrôlée (et faiblement) les constituants pour permettre une faible migration des constituants en surface des zones exposées et former ainsi un faible rebord.

On peut prévoir par exemple un solvant (pouvant dissoudre les sels photosensibles et /ou le polymère activé) choisi parmi : cyclopentanone, PGMEA, acétone ; gamma-butyrolactone ... On peut prévoir par exemple l'Isopropylalcool comme solvant ne réagissant pas.

Selon un mode de réalisation, la résine photosensible peut être composée de résine époxyde, de carbonate de propylène, d'un amorceur triaryl-sulfonium et d'un solvant organique (cyclopentanone ou gamma-butyrolactone), comme par exemple une résine de type SU-8.

Selon un mode de réalisation, la couche de résine photosensible peut être déposée à l'étape ab- sur une surface du substrat non conductrice de l'électricité.

Un autre aspect de l'invention revendiquée se rapporte à un procédé de fabrication d'une pièce métallique (par galvanoplastie et/ou croissance métallique, par électrodéposition ou par dépôt autocatalytique), comprenant les étapes consistant à :
- fournir un moule fabriqué avec le procédé revendiqué de fabrication d'un moule ,
- fabriquer ou former la pièce métallique par croissance métallique galvanique ou autocatalytique dans l'empreinte du moule.

Selon un mode de réalisation, la pièce métallique peut être une pièce horlogère.

### Description des figures

D'autres caractéristiques et avantages de la présente invention apparaîtront plus clairement à la lecture de la description détaillée qui suit de différents modes de réalisation de l'invention donnés à titre d'exemples nullement limitatifs et illustrés par les dessins annexés, dans lesquels :
[fig. 1] à [fig. 6] représentent des étapes de fabrication d'un moule selon une première mise en œuvre d'un procédé selon le premier aspect de l'invention ;
[fig. 7] à [fig. 11] représentent des étapes de fabrication d'un moule selon une deuxième mise en œuvre d'un procédé selon le premier aspect de l'invention ;
[fig. 12] à [fig. 16] représentent des étapes de fabrication d'un moule selon une variante de la deuxième mise en œuvre d'un procédé selon le premier aspect de l'invention ;
[fig. 17] à [fig. 21] représentent des étapes de fabrication d'un moule selon une troisième mise en œuvre d'un procédé selon le premier aspect de l'invention ;
[fig. 22] à [fig. 26] représentent des étapes de fabrication d'un moule selon une quatrième mise en œuvre d'un procédé selon le premier aspect de l'invention ;
[fig. 27] représente une étape d'une mise en œuvre alternative de la première, ou de la deuxième ou de la troisième ou de la quatrième mise en œuvre d'un procédé selon le premier aspect de l'invention ;
[fig. 28] représente une étape optionnelle de la variante de la deuxième mise en œuvre d'un procédé selon le premier aspect de l'invention des figures 12 à 16 ;
[fig. 29] représente une étape alternative et/ou optionnelle de la troisième mise en œuvre d'un procédé selon le premier aspect de l'invention des figures 17 à 21 ;
[fig. 30] représente une étape alternative et/ou optionnelle de la quatrième mise en œuvre d'un procédé selon le premier aspect de l'invention des figures 22 à 26
[fig. 31] et [fig. 32] représentent une alternative de la variante de la deuxième mise en œuvre d'un procédé selon le premier aspect de l'invention des figures 12 à 16 ;
[fig. 33] représente une autre étape optionnelle de la troisième mise en œuvre de l'invention des figures 17 à 21, ou de la quatrième mise en œuvre d'un procédé selon le premier aspect de l'invention des figures 22 à 26 ;
[fig. 34] représente une étape d'un procédé de fabrication d'un moule selon le troisième aspect de l'invention avec la fourniture d'un substrat conducteur ;
[fig. 35] représente une autre étape du procédé de fabrication d'un moule selon le troisième aspect de l'invention avec la formation d'une couche épaisse de résine photosensible sur le substrat ;
[fig. 36] représente une autre étape du procédé de fabrication d'un moule selon le troisième aspect de l'invention avec l'irradiation sélective de la couche épaisse de résine photosensible ;
[fig. 37] représente une autre étape du procédé de fabrication d'un moule selon le troisième aspect de l'invention avec la dépose d'une couche solvantée au dessus de la couche épaisse de résine photosensible ;
[fig. 38] représente une autre étape du procédé de fabrication d'un moule selon le troisième aspect de l'invention avec le développement de la couche épaisse de résine photosensible ;
[fig. 39] représente une autre étape du procédé de fabrication d'un moule selon le troisième aspect de l'invention avec le dépôt physique d'un métal en phase vapeur au fond de cavités de la couche épaisse de résine photosensible développée.

### Description détaillée de mode(s) de réalisation

D'une manière générale, le premier aspect de l'invention décrit ci-dessous est un procédé qui permet de fabriquer un moule avec la garantie d'un dépôt de la couche de résine épaisse qui adhère fortement au substrat, c'est-à-dire avec des risques de décollement de la résine structurée limités ou réduits, de même pour les phénomènes de croissance sous la résine structurée (infiltrations). Le deuxième aspect de l'invention est relatif à un moule pour former des pièces métalliques, le moule ayant un rebord qui s'étend au dessus d'une partie de l'empreinte. Le troisième aspect de l'invention est relatif à un procédé qui permet de fabriquer un moule ayant un rebord qui s'étend au dessus d'une partie de l'empreinte. Le quatrième aspect est relatif à un procédé de fabrication d'une pièce dans un moule fabriqué avec le procédé du premier aspect de l'invention et/ou du troisième aspect de l'invention. En particulier, le procédé du premier aspect de l'invention et le procédé du troisième aspect de l'invention sont complémentaires et peuvent être combinés pour fabriquer un moule avec un couche de résine structurée ayant une bonne adhésion au substrat et ayant au moins un rebord qui s'étend au dessus d'une partie de l'empreinte (ou des cavités).

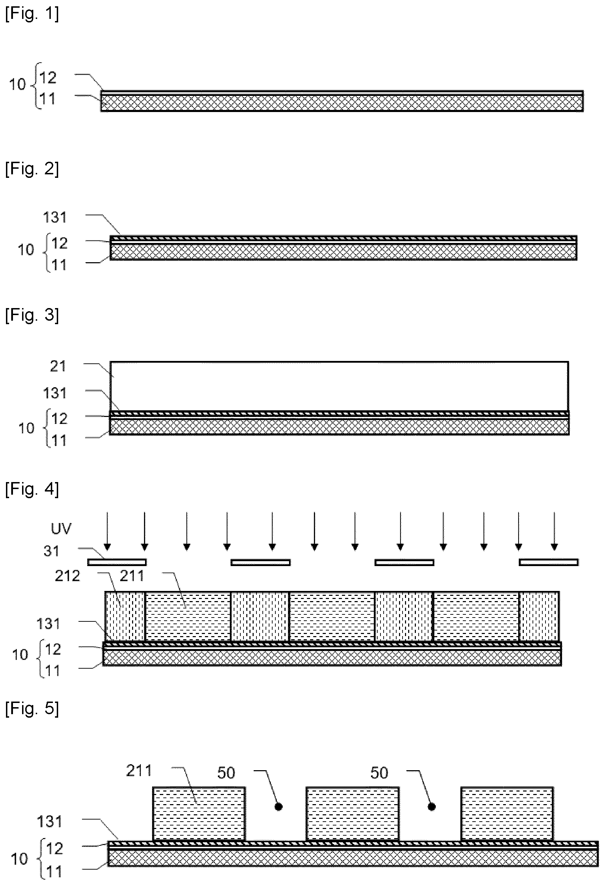

Les figures 1 à 6 représentent des étapes de fabrication d'un moule selon une première mise en œuvre d'un procédé selon le premier aspect de l'invention, dans laquelle le procédé à une première étape consiste à se munir d'un substrat 10 comprenant une âme 11 en silicium et une couche conductrice de base 12.

L'âme 11 est une plaquette en silicium, mais on peut envisager d'utiliser une plaquette en verre, ou une plaquette en céramique ou même une plaquette métallique. La couche conductrice de base 12 peut comprendre une sous couche de chrome ou de titane ou de tantale et une couche d'or ou de cuivre ou de palladium ou de platine ou tout matériau conducteur compatible avec un procédé galvanique.

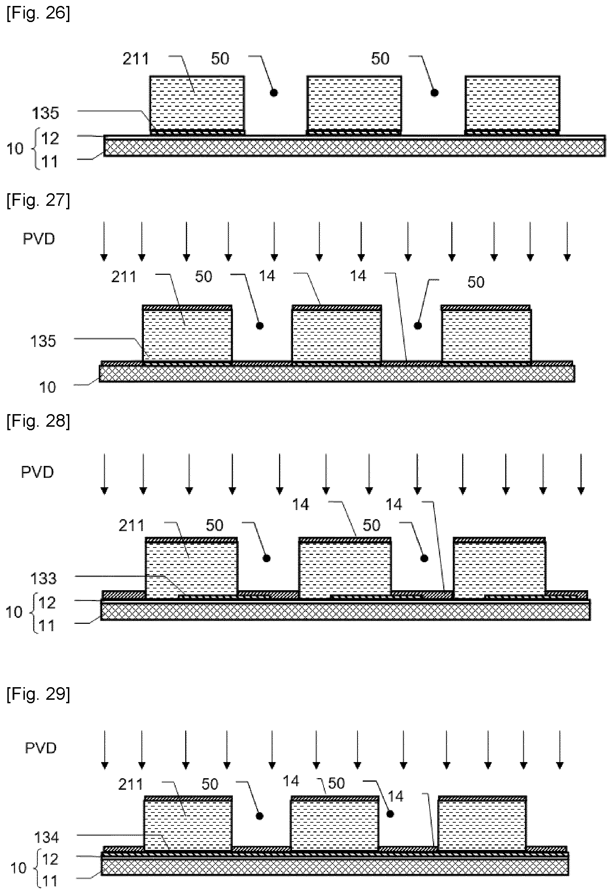

On peut noter que la couche conductrice de base 12 est optionnelle et peut être omise, notamment si les pièces métalliques sont à former avec un procédé « electroless » ou par dépôt autocatalytique. Cette option, applicable à toutes les mises en œuvre ci-dessous décrites, sera détaillée à la figure 27, il faut simplement prévoir une couche propice à amorcer la réaction catalytique. On peut noter que la couche conductrice de base 12 peut être optionnelle même dans le cadre de formation des pièces métalliques par croissance métallique galvanique, si une couche conductrice commune est formée (par exemple par dépôt physique en phase vapeur) avant le dépôt de la couche épaisse de résine.

La figure 2 représente une deuxième étape, avec la dépose d'une couche d'accroche 131 sur la couche conductrice de base 12. Dans cette mise en œuvre, la couche d'accroche 131 est une fine couche de résine photosensible, avec une épaisseur très fine, typiquement inférieure à 1 µm. on peut prévoir d'utiliser une résine de type SU8-2000.5 qui est déposée sur toute la surface de la couche conductrice de base 12. Par exemple, on peut utiliser une résine très liquide que l'on étale par spin coating, avec une vitesse de rotation comprise entre 1000 tours/minute et 2500 tours/minute pendant 20 à 90 secondes. L'accélération peut être de 100 à 500 tours/minute par seconde. On peut utiliser un comparateur précis à 0.5 micron pour connaitre l'épaisseur sur toute la plaque. Une étape d'exposition à un rayonnement ultraviolet est possible, voire préférable, mais pas obligatoire. Un recuit (un « post-bake » ou « hardbake ») est ensuite effectué à une température par exemple supérieure à 150°C, de sorte que la résine de la couche d'accroche 13 réticule complètement et ramollisse suffisamment (avec de faibles contraintes grâce à la faible épaisseur) pour adhérer fortement à une couche épaisse de résine photosensible qui sera ensuite appliquée.

En effet, la figure 3 représente le moule de la figure 2 recouvert d'une couche épaisse de résine photosensible 21 qui formera en tout ou partie le moule à proprement parler. On peut appliquer une résine photosensible 21 liquide ou visqueuse, par exemple à la tournette ou par application au cylindre, ou on peut alternativement déposer / laminer une couche de résine solide du type film sec ou une feuille sèche de résine.

En tout état de cause, la fine couche d'accroche 131 réticulée et ramollie par le traitement thermique permet une adhérence élevée de la résine photosensible 21.

La résine photosensible 21 est une résine photosensible négative couramment utilisée dans la fabrication de microsystèmes. Il s'agit d'un polymère très visqueux qui peut être tourné (dépose à la tournette) ou étalé sur une épaisseur allant de 1 micromètre à 2 millimètres. On peut par exemple utiliser une résine SU-8 composée de résine époxyde, de carbonate de propylène, de l'amorceur triaryl-sulfonium et d'un solvant organique (cyclopentanone ou gamma-butyrolactone, selon la formulation). On peut ensuite effectuer un chauffage ou un recuit (« pre-bake ») pour évaporer le ou les solvants et pour solidifier la résine.

On peut déposer la résine photosensible 21 en une ou plusieurs fois, sous forme visqueuse ou liquide, mais on peut également déposer une couche de résine photosensible 21 polymérisée et préparée à l'avance, comme une couche de solide de résine (film sec ou une feuille sèche de résine).

La figure 4 montre l'étape d'irradiation à un rayonnement UV de la résine photosensible 21 au travers d'un masque 31, pour activer ou réticuler les parties de la résine photosensible 21 en regard des ouvertures du masque 31. Pour la résine SU-8 susmentionnée, on peut effectuer une irradiation à un rayonnement UV de longueur d'onde de 365 nm.

Comme le montre la figure 4, la résine photosensible 21 présente des parties activées 211 et des parties non activées 212. A l'issue de l'étape d'irradiation, un recuit peut encore être effectué, avant l'étape de développement dans un bain de solvant (par exemple du Propylène glycol méthyl éther acétate pour la résine SU-8). A l'issue du développement, les parties non activées 212 sont dissoutes et le moule de la figure 5 est obtenu.

On peut noter que les parties activées 211 forment des motifs en relief, entourant des cavités 50 qui laissent apparaître la couche d'accroche 131. Les cavités 50 forment typiquement une ou plusieurs empreinte(s) pour réaliser la déposition de métal et former ainsi des pièces métalliques par galvanoplastie et/ou croissance métallique.

On peut noter que l'exemple décrit fait appel à une résine négative, mais on peut envisager d'utiliser une résine positive. De plus, il est possible de déposer, irradier et développer successivement plusieurs couches de résine photosensible pour créer un moule multi niveaux.

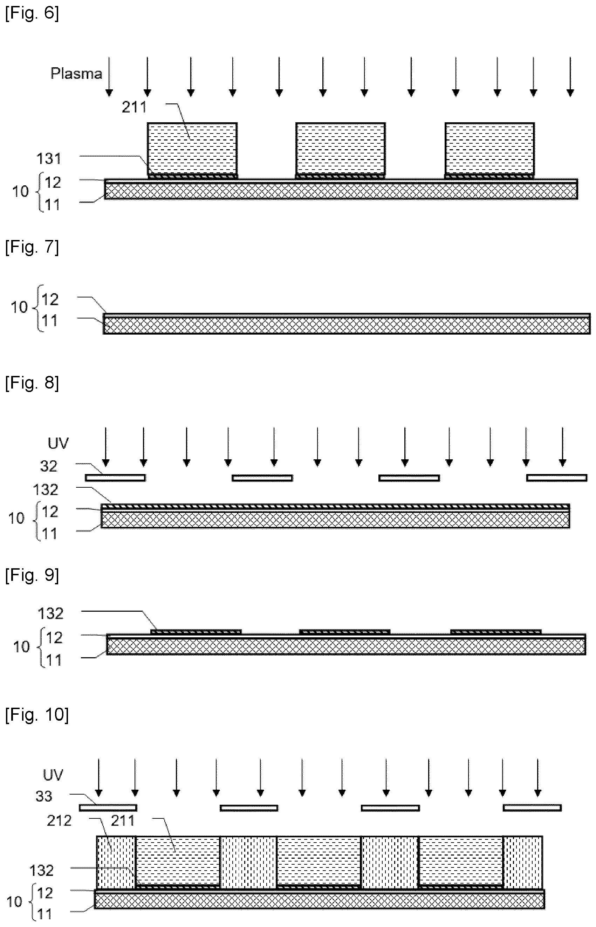

Comme indiqué ci-dessus, la couche d'accroche 131 est apparente au fond des cavités 50. Afin de rendre le moule apte à former des pièces métalliques par électrodéposition, on peut prévoir un traitement plasma comme montré en figure 6 afin de dégager la couche conductrice de base 12. Le traitement plasma peut typiquement être à base des gaz CF₄/O₂, et ajusté pour retirer juste l'épaisseur de la couche d'accroche 13, c'est-à-dire 1 µm de résine photosensible. On peut noter que cette étape pourrait être remplacée et/ou complétée par un dépôt d'une matière conductrice au fond des cavités 50, comme par exemple un dépôt physique d'or en phase vapeur, qui peut alors être relié électriquement à une surface conductrice de base 12, par exemple au moins au milieu des cavités 50 et/ou empreintes. Dans le cas d'une formation de pièces métalliques par dépôt autocatalytique (« electroless »), cette étape consistant à rendre le fond des cavités 50 conducteur de l'électricité est superflue et peut être remplacée par une étape consistant à déposer une couche pour amorcer la réaction catalytique, comme du platine ou du palladium.

Les figures 7 à 11 représentent des étapes de fabrication d'un moule selon une deuxième mise en œuvre d'un procédé selon le premier aspect de l'invention. La figure 7 montre une première étape consistant également à se munir d'un substrat 10 comprenant une âme 11 en silicium et une couche conductrice de base 12.

L'âme 11 est une plaquette en silicium, mais on peut envisager d'utiliser une plaquette en verre, ou une plaquette en céramique ou même une plaquette métallique. La couche conductrice de base 12 peut comprendre une sous couche de chrome ou de titane et une couche d'or ou de cuivre.

On peut noter que la couche conductrice de base 12 est optionnelle et peut être omise, en particulier si les pièces métalliques sont à former avec un procédé « electroless » ou par dépôt autocatalytique (la couche conductrice de base 12 peut être remplacée par une couche pour amorcer la réaction catalytique, comme une couche de platine ou de palladium). Cette option, applicable à toutes les mises en œuvre ci-dessous décrites, sera détaillée plus avant à la figure 27.

La figure 8 représente une deuxième étape, avec la dépose d'une couche d'accroche 132 sur la couche conductrice de base 12. Dans cette mise en œuvre, la couche d'accroche 132 est une couche de résine photosensible d'une épaisseur d'environ 20 µm ou moins. Cette couche d'accroche 132 de résine photosensible va être structurée pour former des motifs supports à la couche épaisse de résine ultérieure qui formera ultérieurement le moule.

Pour cette couche d'accroche 132 de résine photosensible, on peut par exemple utiliser une résine SU-8 composée de résine époxyde, de carbonate de propylène, de l'amorceur triaryl-sulfonium et d'un solvant organique (cyclopentanone ou gamma-butyrolactone, selon la formulation). On peut ensuite effectuer un chauffage ou un recuit (« pre-bake ») pour évaporer le ou les solvants et pour solidifier la résine. Comme le montre la figure 8, l'étape d'irradiation à un rayonnement UV de la résine photosensible de la couche d'accroche 132 au travers d'un masque 32, pour activer ou réticuler des parties d'accroche de la résine photosensible de la couche d'accroche 132 en regard des ouvertures du masque 32. Pour la résine SU-8 susmentionnée, on peut effectuer une irradiation à un rayonnement UV de longueur d'onde de 365 nm.

A l'issue de l'étape d'irradiation, un recuit peut encore être effectué, avant l'étape de développement dans un bain de solvant (par exemple du Propylène glycol méthyl éther acétate pour la résine SU-8). A l'issue du développement, les parties non activées de la couche d'accroche 132 sont dissoutes et le moule de la figure 9 est obtenu. On peut alors faire un traitement thermique à une température d'au moins 140°C. Les parties subsistantes de la couche d'accroche 132 de la figure 9 présentent alors un bon pouvoir adhésif.

En effet, la figure 10 montre le moule de la figure 9 avec une couche de résine photosensible déposée de la même manière que pour le premier mode de réalisation figure 3 (pré-recuit, irradiation, post-recuit), et en cours d'irradiation au travers d'un masque 33 pour former des parties activées 211 et des parties non activées 212.

On peut noter que le masque 32 utilisé pour irradier la couche d'accroche 132 à la figure 8 et le masque 33 utilisé pour irradier la couche épaisse de résine photosensible à la figure 10 sont prévus et alignés pour irradier les mêmes zones du moule. En conséquence, les parties activées 211 reposent sur les parties activées et développées de la couche d'accroche 132.

Grâce à la faible épaisseur de la couche d'accroche 132 et au post-recuit au-delà de 140°C appliqué à la couche d'accroche 132, cette dernière présente une bonne adhérence sur le substrat 10, et il en va de même pour les parties activées 211 qui reposent sur les parties activées et développées de la couche d'accroche 132.

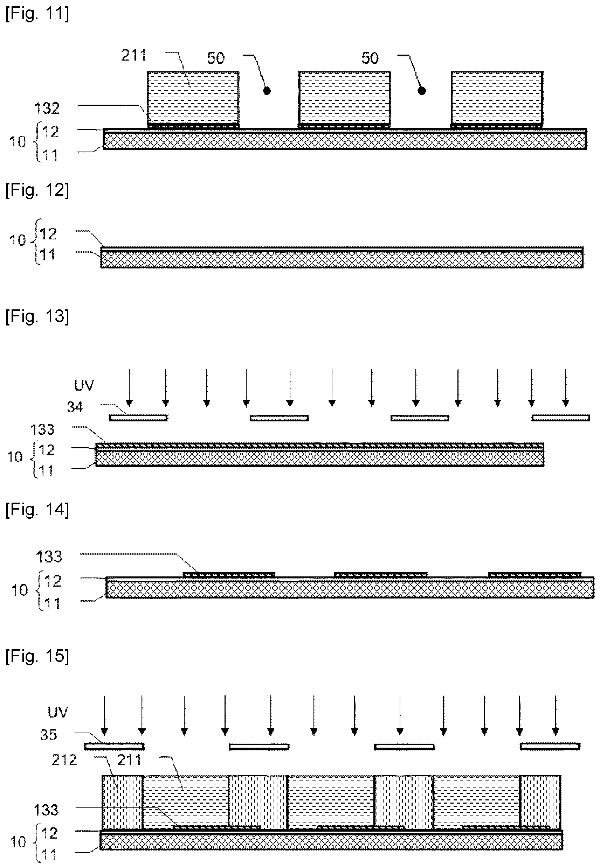

La figure 11 montre le moule de la figure 10 après développement de la résine photosensible de la couche épaisse de résine photosensible, avec des cavités 50 qui débouchent sur la couche conductrice de base 12

En résumé de ce deuxième mode de réalisation, et en ce qui concerne la couche d'accroche 132, on peut noter les étapes suivantes :
- dépose d'une couche d'environ 20 µm ou moins sur le substrat 10,
- réticulation de certaines parties avec un masque 32 (avec éventuellement des traitements thermiques),
- développement de la couche d'accroche 132,
- application spécifique d'un traitement thermique au-delà de 140°C aux parties subsistantes de la couche d'accroche 132,
- recouvrement par une couche épaisse de résine photosensible qui adhère fortement aux parties subsistantes de la couche d'accroche 132, et qui est destinée à former des cavités pour former les empreintes du moule.

Les figures 12 à 16 représentent des étapes de fabrication d'un moule selon une variante de la deuxième mise en œuvre d'un procédé selon le premier aspect de l'invention. Cette variante de la deuxième mise en œuvre :
- comprend, comme pour la deuxième mise en œuvre, la formation sur le substrat 10 d'une couche d'accroche 133 en résine photosensible d'environ 20 µm ou moins qui est structurée (partiellement irradiée et développée), recuite et recouverte ensuite par une couche épaisse de résine photosensible ultérieurement structurée (partiellement irradiée et développée) ;
- diffère de la deuxième mise en œuvre notamment en ce que les masques utilisés pour l'irradiation de la couche d'accroche et de la couche épaisse de résine photosensible sont décalés et/ou différents.

Dans le détail, la figure 12 montre la première étape consistant à se munir d'un substrat 10 constitué par une plaquette recouverte d'une couche conductrice de base 12.

La figure 13 représente une deuxième étape consistant à recouvrir la surface supérieure du substrat 10 avec de la résine photosensible pour former une couche d'accroche 133, et à irradier cette couche d'accroche avec un masque 34.

La figure 14 montre le moule de la figure 13 après développement, les parties réticulées de la couche d'accroche 133 subsistant sur le substrat 10. Un traitement thermique peut alors être effectué à plus de 140°C.

Le moule peut alors être recouvert d'une couche de résine photosensible épaisse qui est irradiée au travers d'un masque 35 comme le montre la figure 15. On peut noter que les masques 34 et 35 sont différents, de sorte à irradier différentes zones du moule. Toutefois, des zones communes sont irradiées, si bien que les parties activées 211 reposent au moins partiellement sur les parties réticulées et subsistantes de la couche d'accroche 133.

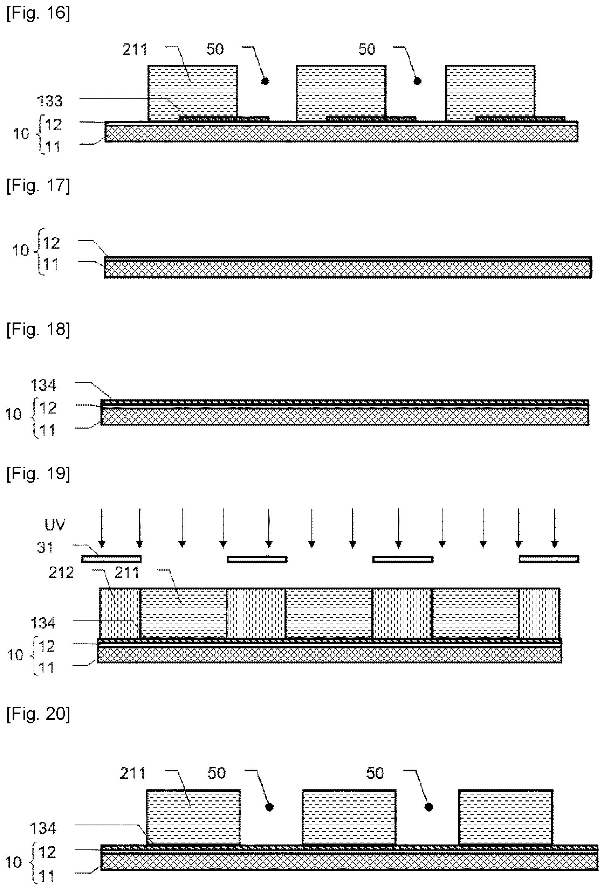

La couche de résine épaisse peut alors être développée à son tour pour former des cavités 50 comme le montre la figure 16. On peut noter qu'une partie de la structure de la couche d'accroche 133 est apparente en fond des cavités 50 ou empreintes du moule. Lors de la formation de la pièce métallique, soit les structures de la couche d'accroche 133 sont suffisamment étroites pour permettre de les recouvrir par débordement, soit les structures de la couche d'accroche 133 peuvent être rendues conductrices par exemple avec un dépôt physique de matière conductrice en phase vapeur sur toute la surface en fond de cavité avant le dépôt dans le moule.

. Comme le montre la figure 28, un dépôt physique d'or en phase vapeur (PVD, avec de préférence une sous-couche d'accroche de chrome ou titane ou tantale...) est ensuite appliqué pour former une couche conductrice de recouvrement 14 sur la surface structurée de la couche d'accroche 133 pour rendre conductrice toute la surface en fond de cavité 50 avant formation des pièces métalliques par galvanoplastie et/ou croissance métallique (avec la couche conductrice de base 12 qui forme une connexion électrique commune, ou une « mise à la masse »). Les structurations de la couche d'accroche 133 procurent toutefois des points d'ancrage aux couches épaisses de résine photosensible.

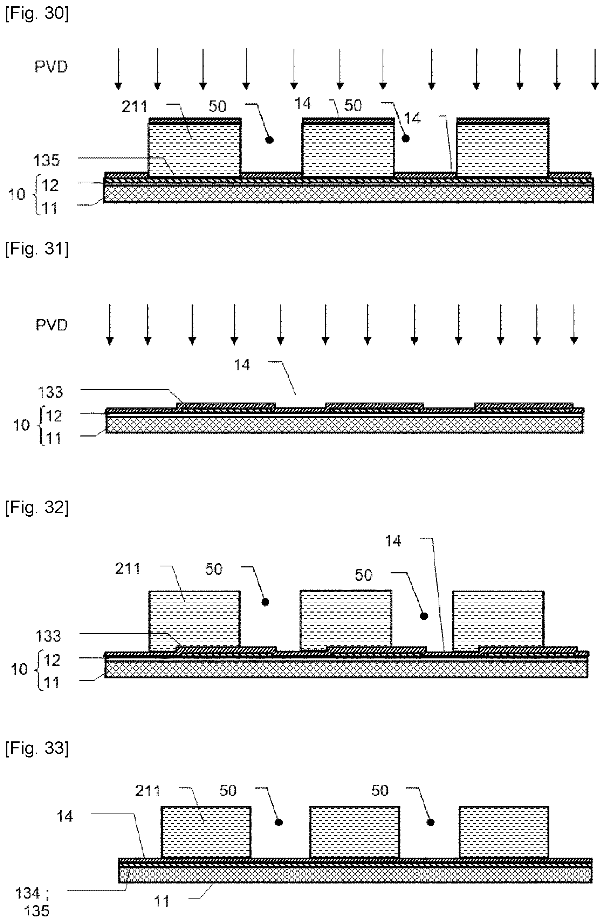

Les figures 31 et 32 montrent une alternative du procédé de fabrication à partir de l'étape montrée figure 14, pour fabriquer un moule destiné à former des pièces métalliques par croissance métallique galvanique, toujours selon un procédé selon le premier aspect de l'invention. En effet, la figure 31, à partir du moule obtenu figure 14, montre une étape de formation d'une couche conductrice de revêtement 14, au dessus des structures de la couche d'accroche 133. La figure 32 montre le moule terminé, obtenu après dépose et développement d'une couche de résine épaisse dont il subsiste les parties activées 211, définissant des cavités 50.

Dans le cas d'une pièce métallique formée par croissance métallique autocatalytique, le dépôt physique en phase vapeur de la figure 28 pourra consister à déposer du platine ou du palladium par exemple, et la couche conductrice de base 12 est optionnelle. Dans ce dernier cas les structures de la couche d'accroche 133 peuvent être déposées directement sur des plaquettes en silicium ou silicium oxydé permettant ainsi une meilleure adhésion des structures de la couche d'accroche 133.

Les figures 17 à 21 représentent une mise en œuvre du procédé de fabrication selon l'invention, avec notamment la dépose sous vide d'une couche d'accroche en silicium.

Dans le détail, la figure 17 représente une première étape consistant à se munir d'un substrat 10 (ici une plaquette 11 en silicium avec une couche conductrice de base 12).

La figure 18 représente une deuxième étape avec la formation d'une couche d'accroche 134 formée par une fine couche de silicium déposée sous vide et présentant une épaisseur inférieure à 50 nm, de préférence inférieure à 20 nm. Une telle couche en silicium présente une forte adhérence avec la résine photosensible.

La figure 19 représente la dépose et l'irradiation d'une résine photosensible (par exemple du type SU-8) au travers d'un masque 31 pour définir des parties activées 211 et des parties non activées 212.

Le figure 20 montre le moule de la figure 19 après développement de la couche de résine épaisse pour définir des cavités de moulage 50 pour la formation de pièces métalliques.

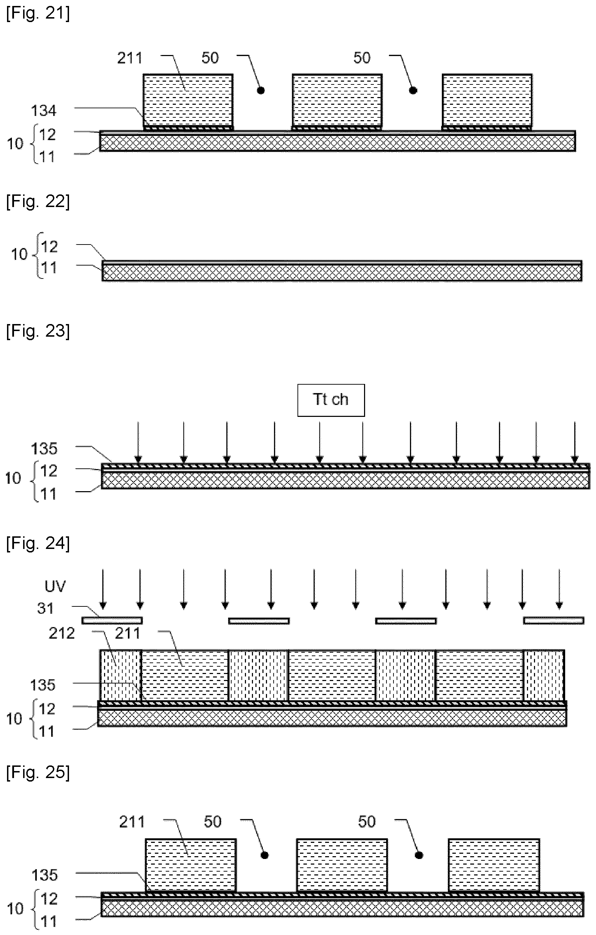

Cependant, la couche d'accroche 134 est apparente au fond des cavités 50 (figure 20), et la figure 21 montre le moule de la figure 20 après gravure de cette couche d'accroche 134 apparente au fond des cavités 50. On peut faire une gravure par plasma ionique réactif (RIE) ou par plasma chimique généré à partir de gaz CF₄/O₂ ou une gravure chimique humide (avec de la soude NaOH, ou de l'hydroxyde de potassium KOH ou de l'acide fluorhydrique HF).

On pourra noter que pour former des pièces métalliques par croissance métallique sans courant (dépôt autocatalytique ou « electroless »), cette dernière étape est optionnelle et/ou superflue. On peut prévoir une fine couche de platine ou de palladium ou fond des cavités 50 (dépôt physique en phase vapeur), ou une couche de nickel par déposition galvanique.

Selon une autre possibilité illustrée figure 29, toujours selon un procédé selon le premier aspect de l'invention, on peut prévoir de recouvrir le fond des cavités 50 par une fine couche d'or (ou toute matière propice au dépôt galvanique : argent, cuivre, platine, palladium...) avec un dépôt physique sous forme vapeur (PVD) pour former une couche de recouvrement 14. Le silicium étant très fin, le courant électrique peut passer au travers lors de la fabrication de la pièce métallique par croissance métallique galvanique (la couche conductrice 12 faisant office de masse commune à toutes les cavités 50 munies de la couche de recouvrement 14).

Selon encore une autre possibilité, toujours selon un procédé selon le premier aspect de l'invention, comme le montre la figure 33, on peut prévoir de déposer par dépôt physique en phase vapeur une fine couche de matière conductrice (de l'or, ou toute matière propice au dépôt galvanique : argent, cuivre, platine, palladium...) directement sur la fine couche de silicium formant la couche d'accroche 134. Cette étape peut être effectuée juste après l'étape de la figure 18, avant dépose et structuration de la couche épaisse de résine définissant les parties activées 211 et les cavités 50. Dans ce cas, la couche conductrice de base 12 n'est pas nécessaire.

Dans le cas d'une pièce métallique formée par croissance métallique autocatalytique, le dépôt physique sous forme vapeur (PVD) pour former une couche de recouvrement 14 de la figure 29 ou de la figure 33 peut consister à déposer une fine couche de platine ou de palladium.

Les figures 22 à 26 représentent une quatrième mise en œuvre du procédé de fabrication d'un moule pour former des pièces métalliques par galvanoplastie et/ou croissance métallique selon l'invention, avec notamment la formation d'une couche d'accroche d'oxyde métallique ou d'oxyde metalloïde qui est fonctionnalisée en déposant une couche de promotion adhésive.

Dans le détail, la figure 22 représente une première étape consistant à se munir d'un substrat 10 (ici une plaquette 11 en silicium avec une couche conductrice de base 12).

La figure 23 représente une deuxième étape avec la formation d'une couche d'accroche 135 formée d'abord par une couche d'oxyde métallique ou d'oxyde metalloïde ensuite fonctionnalisée en déposant une couche de promotion adhésive.

En particulier, on peut prévoir une couche de dioxyde de silicium SiO₂ ou en oxyde de métal, comme un oxyde de métal pauvre tel que de l'alumine Al₂O₃ ou un oxyde de métal de transition comme du dioxyde de titane TiO₂. Pour générer une telle couche, on peut prévoir de déposer un métal ou un métalloïde par dépôt physique en phase vapeur comme de l'aluminium Al, du titane Ti, du silicium Si, et une étape consistant à oxyder ou à laisser s'oxyder à l'air le métal ou le métalloïde pour avoir en surface de l'oxyde métallique ou de l'oxyde metalloïde comme de l'alumine Al2O3, du dioxyde de titane TiO₂, du dioxyde de silicium SiO₂.

Ensuite, un traitement chimique (Tt ch sur la figure 23) est effectué pour obtenir une bonne capacité d'adhérence avec de la résine photosensible. On peut déposer une couche de promotion adhésive préférentiellement organique comprenant par exemple une fonction capable de former une liaison avec la couche d'accroche d'oxyde métallique ou d'oxyde metalloïde, et plus préférentiellement comprenant une fonction silanol, phosphonate, thiol, amine, époxyde, acide carboxylique.

La figure 24 représente la dépose sur la couche d'accroche 135 avec sa couche de promotion adhésive et l'irradiation d'une couche épaisse résine photosensible (par exemple du type SU-8) au travers d'un masque 31 pour définir des parties activées 211 et des parties non activées 212.

Le figure 25 montre le moule de la figure 24 après développement de la couche de résine épaisse pour définir des cavités de moulage 50 pour la formation de pièces métalliques.

Cependant, la couche d'accroche 135 est apparente au fond des cavités 50 (figure 25), et la figure 26 montre le moule de la figure 25 après gravure de cette couche d'accroche 135 apparente au fond des cavités 50. On peut faire une gravure de la couche d'accroche 135 en oxyde métallique ou en oxyde metalloïde, avec par exemple une gravure plasma, ou une gravure chimique par voie humide avec de la soude ou de de l'hydroxyde de potassium, ou avec un acide comme de l'acide fluorhydrique HF ou de l'acide fluorhydrique tamponné BHF.

On pourra noter que pour former des pièces métalliques par galvanoplastie et/ou croissance métallique sans courant (dépôt autocatalytique ou « electroless »), cette dernière étape est optionnelle et/ou superflue.

Selon une autre possibilité illustrée figure 30, toujours selon un procédé selon le premier aspect de l'invention, on peut prévoir de recouvrir le fond des cavités 50 par une fine couche d'or (ou toute matière propice au dépôt galvanique : argent, cuivre, platine, palladium...) avec un dépôt physique sous forme vapeur (PVD) pour former une couche de recouvrement 14. L'oxyde de métalloïde ou l'oxyde métallique et la couche d'accroche 135 étant très fins et/ou la gravure de la couche 135 laissant apparaître au moins localement la couche conductrice de base 12, le courant électrique peut passer au travers de la couche d'accroche 135 lors de la fabrication de la pièce métallique par croissance métallique galvanique (la couche conductrice 12 faisant office de masse commune à toutes les cavités 50 munies de la couche de recouvrement 14).

Selon encore une autre possibilité, toujours selon un procédé selon le premier aspect de l'invention, comme le montre la figure 33, on peut prévoir de déposer par dépôt physique en phase vapeur une fine couche de matière conductrice (de l'or, ou toute matière propice au dépôt galvanique : argent, cuivre, platine, palladium...) directement sur la fine couche d'oxyde de métalloïde ou d'oxyde métallique et la couche d'accroche 135. Cette étape peut être effectuée juste après l'étape de la figure 23, avant dépose et structuration de la couche épaisse de résine définissant les parties activées 211 et les cavités 50. Dans ce cas, la couche conductrice de base 12 n'est pas nécessaire.

Comme mentionné ci-dessus, la présence de la couche conductrice de base 12 est optionnelle (pour une pièce métallique formée par croissance métallique autocatalytique), et on peut prévoir pour toutes les mises en œuvre ci-dessus d'utiliser un substrat 10 sans surface conductrice de base 12. Dans le cas d'une pièce métallique formée par croissance métallique autocatalytique, le dépôt physique en phase vapeur de la figure 30 pourra consister à déposer du platine ou du palladium par exemple pour former la couche de recouvrement 14, et la couche conductrice de base 12 est optionnelle. En effet, pour former des pièces métalliques par galvanoplastie et/ou croissance métallique sans courant (par dépôt autocatalytique, « electroless »), il faut prévoir que la surface au fond des cavités 50 soit propice à l'amorçage de la réaction catalytique.

Cependant, pour un dépôt par électrodéposition, on peut prévoir la formation d'une couche conductrice 14 en fond de cavités 50 comme le montre la figure 27 pour le moule de la quatrième mise en œuvre obtenu après le développement de la couche de résine photosensible épaisse. On peut noter que le substrat 10 comprendra une couche conductrice de base 12 qui procure une connexion électrique à toutes les cavités 50 (« masse commune »).

Dans le cas où la pièce métallique est formée par croissance métallique galvanique (électrodéposition), le substrat 10 comprend une couche conductrice de base 12 et un dépôt physique d'or en phase vapeur conduit à former une couche conductrice de recouvrement 14 homogène au fond des cavités 50 (même si par exemple des impuretés subsistent), et au sommet des parties activées 211. On peut prévoir d'ajuster le dépôt physique d'or en phase vapeur pour obtenir une couche conductrice de l'électricité en fond des cavités 50, mais pas sur les flancs des parties activées 211. Si la couche d'accroche est une couche fine de silicium, le courant peut passer au travers et la couche conductrice de recouvrement 14 au fond des cavités 50 est ainsi connectée électriquement à la couche conductrice de base 12 recouvrant le substrat 10. Si la couche d'accroche est une couche fine de metalloïde comme le titane ou l'aluminium, le courant peut passer et la couche conductrice de recouvrement 14 en or ou en platine ou en palladium au fond des cavités 50 rend le moule compatible avec une croissance métallique galvanique (électrodéposition).

Dans le cas où la pièce métallique est formée par croissance métallique autocatalytique, le substrat 10 ne comprend pas forcément de couche conductrice de base 12, mais la surface au fond des cavités 50 doit être propice à l'amorçage de la réaction catalytique, si bien que l'on peut déposer une fine couche de platine ou de palladium ou fond des cavités 50, comme on le fait pour le dépôt d'or de la figure 27.

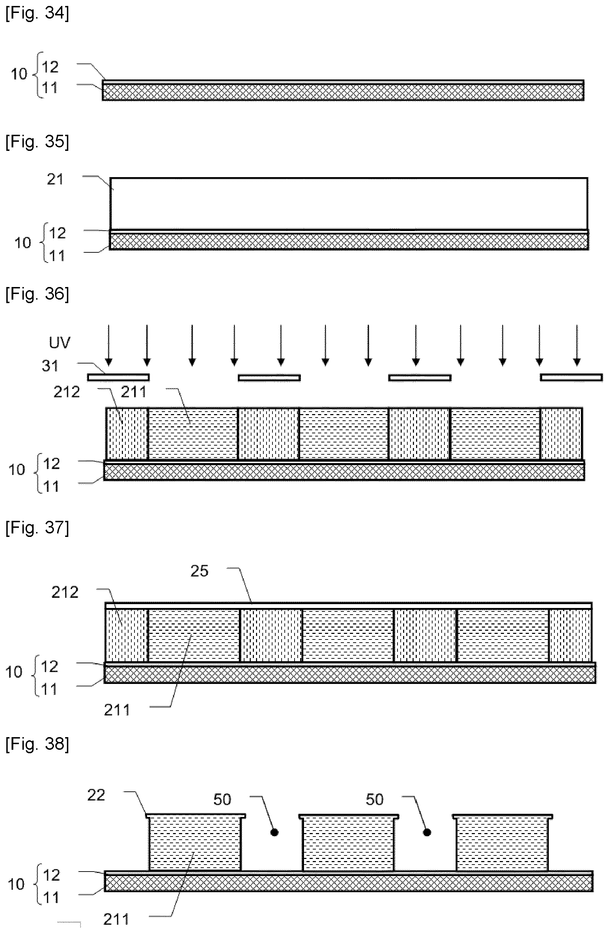

La figure 34 représente une première étape d'un procédé de fabrication d'un moule selon le troisième aspect de l'invention qui consiste à se munir d'un substrat 10 comprenant une âme 11 en silicium et une couche conductrice de base 12.

L'âme 11 est une plaquette en silicium, mais on peut envisager d'utiliser une plaquette en verre, ou une plaquette en céramique ou même une plaquette métallique. La couche conductrice de base 12 peut comprendre une sous couche de chrome ou de titane et une couche d'or ou de cuivre.

On peut noter que la couche conductrice de base 12 est optionnelle et peut être omise.

La figure 35 représente le moule de la figure 34 recouvert d'une couche épaisse de résine photosensible 21 qui formera en tout ou partie le moule à proprement parler. On peut appliquer une résine photosensible 21 liquide ou visqueuse, par exemple à la tournette ou par application au cylindre, ou on peut alternativement déposer / laminer une couche de résine solide du type lamina (un film sec ou une feuille sèche de résine, à laminer).

La résine photosensible 21 est une résine photosensible négative couramment utilisée dans la fabrication de microsystèmes. Il s'agit d'un polymère très visqueux qui peut être tourné (dépose à la tournette) ou étalé sur une épaisseur allant de 1 micromètre à 2 millimètres. On peut par exemple utiliser une résine SU-8 composée de résine époxyde, de carbonate de propylène, de l'amorceur triaryl-sulfonium et d'un solvant organique (cyclopentanone ou gamma-butyrolactone, selon la formulation). On peut ensuite effectuer un chauffage ou un recuit (« pre-bake ») pour évaporer le ou les solvants et pour solidifier la résine.

On peut déposer la résine photosensible 21 en une ou plusieurs fois, sous forme visqueuse ou liquide ou encore solide (un film sec ou une feuille sèche de résine non réticulée, à laminer), mais on peut également déposer une couche de résine photosensible 21 polymérisée et préparée à l'avance.

La figure 36 montre l'étape d'irradiation à un rayonnement UV de la résine photosensible 21 au travers d'un masque 31, pour activer ou réticuler les parties de la résine photosensible 21 en regard des ouvertures du masque 31. Pour la résine SU-8 susmentionnée, on peut effectuer une irradiation à un rayonnement UV de longueur d'onde de 365 nm.

Comme le montre la figure 36, la résine photosensible 21 présente alors des parties activées 211 et des parties non activées 212. A l'issue de l'étape d'irradiation, un recuit peut encore être effectué.

Au lieu de passer à l'étape de développement de la résine photosensible 21, il est proposé de réaliser un premier traitement thermique à une température comprise entre 25°C et 65°C et de déposer sur la résine photosensible 21 partiellement réticulée une couche solvantée 25 (c'est-à-dire une couche formée par un matériau comprenant au moins un solvant pouvant dissoudre les sels activés ou le polymère activé), comme le montre la figure 37, puis de faire un deuxième traitement thermique à une température comprise entre 70°C et 95°C.

Le but de ces opérations est de provoquer une migration ou une diffusion des acides photo-initiateurs présents dans les parties activées 211 vers les parties non activées 212, afin d'étendre depuis les parties activées 211 la réticulation de la résine horizontalement et sur une couche proche de la surface.

D'une manière générale, le premier traitement thermique est effectué pendant une durée allant de 5 min à plusieurs jours pour les plus basses températures. Le premier traitement thermique est effectué préférentiellement de 40 à 60°C de 30 min à 1h. Ce premier traitement thermique a pour effet de provoquer une réticulation plus complète de la résine photosensible 21, pour éviter qu'une trop grande quantité acides photo-initiateurs ne migre vers les parties non activées 212.

En ce qui concerne la couche solvantée 25, celle-ci a pour fonction de provoquer et/ou permettre et/ou véhiculer la migration ou la diffusion des acides photo-initiateurs vers les parties non activées 212. On peut prévoir pour la couche solvantée 25 de simplement déposer de la résine photosensible liquide, ou un gel comprenant un solvant ou un mélange de solvants ou directement un solvant ou un mélange de solvants. Dans le détail, on peut prévoir d'utiliser au moins un premier solvant permettant de dissoudre les sels photosensibles et /ou le polymère activé de la couche épaisse de résine photosensible 21 et un deuxième solvant ne réagissant pas avec le système (pour contrôler et/ou ajuster le pouvoir de dissolution du premier solvant). Ce mélange de solvants dissout de manière contrôlée (et faiblement) les constituants pour permettre une faible migration des constituants en surface des zones exposées et former ainsi un faible rebord. On peut prévoir par exemple un solvant (pouvant dissoudre les sels photosensibles et /ou le polymère activé) choisi parmi : cyclopentanone, PGMEA, acétone ; gamma-butyrolactone ... On peut prévoir par exemple l'Isopropylalcool comme solvant ne réagissant pas.

En ce qui concerne les modes de réalisation avec un gel, en particulier pour former un gel ou un mélange visqueux de solvant, on peut par exemple prévoir de dissoudre dans un solvant (ou un mélange de solvant) un polymère ne réagissant pas avec le système, comme par exemple le polyéthylène glycol ou PEG ou encore la polyvinylpyrrolidone (PVP) ... Un mélange visqueux est plus facile à déposer et les moules après dépôt sont plus faciles à manipuler.

En ce qui concerne le deuxième traitement thermique il peut être effectué pendant une durée allant de 5 min à 5h, pour permettre la réticulation des zones des parties non activées 212 qui ont reçu des acides photo-initiateurs. Ainsi, en surface de la résine photosensible 21, les parties activées 211 « débordent » désormais sur les parties non activées 212 avec des rebords 22 qui restent en place après développement comme le montre la figure 38.

Les rebords 22 de la figure 38 présentent une dimension horizontale comprise entre 2 µm à 20 µm, et de préférence entre 2 µm et 8µm. On peut noter que cette dimension peut être ajustée au moins par :
- la durée et la température du premier traitement thermique (plus ce dernier sera chaud et long, plus les rebords seront étroits car la migration sera rendue plus difficile),
- la durée laissée entre le premier traitement thermique et le deuxième traitement thermique (plus la couche solvantée sera laissée longtemps sur la résine photosensible 21 avant le deuxième traitement thermique, plus les rebords seront larges),
- la quantité et la nature des solvants utilisés.

Après le deuxième traitement thermique appliqué sur le moule de la figure 37, on peut procéder au développement dans un bain de solvant (par exemple du Propylène glycol méthyl éther acétate pour la résine SU-8). A l'issue du développement, les parties non activées 212 sont dissoutes et le moule de la figure 38 est obtenu.

On peut noter que les parties activées 211 munies des rebords 22 forment des motifs en relief, entourant des cavités 50 qui laissent apparaître la couche conductrice de base 12 (qui est optionnelle comme expliqué ci-dessus). Les cavités 50 forment typiquement une ou plusieurs empreinte(s) pour réaliser la déposition de métal et former ainsi des pièces métalliques par galvanoplastie et/ou croissance métallique.

On peut noter que l'exemple décrit fait appel à une résine négative, mais on peut envisager d'utiliser une résine positive. De plus, il est possible de déposer, irradier et développer successivement plusieurs couches de résine photosensible pour créer un moule multi niveaux. Dans ce cas, on peut prévoir de former des rebords 22 sur chaque couche épaisse de résine photosensible, et /ou uniquement sur le haut des structures du dernier niveau.

Même si dans l'exemple représenté le fond des cavités 50 est normalement formé par la couche conductrice de base 12, cette dernière peut être absente ou recouverte de résidus non conducteurs qui affecteront la croissance galvanique.

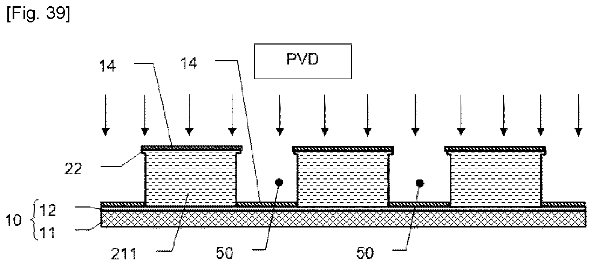

La figure 39 représente le moule de la figure 38 auquel on applique une étape de dépôt physique de métal sous forme vapeur, pour déposer par exemple de l'or au fond des cavités 50 pour former une couche conductrice de recouvrement 14. On peut prévoir d'ajuster l'étape de dépose pour atteindre ou juste dépasser une limite de percolation de conduite de courant électrique au fond des cavités 50, et pas sur les flancs ou parois verticales des parties activées 211, afin de ne pas perturber la croissance galvanique en cas de galvanoplastie par électrodéposition. Autrement dit, le fond des cavités 50 est recouvert d'une couche suffisamment épaisse pour pouvoir conduire le courant électrique, alors que les flancs sont exempts de revêtement conducteur ou avec des particules conductrices trop éloignées les unes des autres pour pouvoir conduire le courant électrique. On peut prévoir d'effectuer le dépôt physique de métal sous forme vapeur de manière directionnelle, selon une direction parallèle aux flancs des cavités 50.

Selon un mode de réalisation, l'étape de formation d'une couche conductrice de recouvrement 14 au fond des cavités 50 peut être effectuée :
- sous niveau de vide inférieur à 10⁻⁴ mbar, et de préférence inférieur à 10⁻⁶ mbar,
- en plaçant par exemple une plaquette de 150 mm de côté ou de diamètre formant le substrat à au moins 500 mm de la source de matière à vaporiser et de préférence à au moins 700 mm de la source de matière à vaporiser, et/ou en chauffant la source de matière à vaporiser juste au dessus de sa température de fusion,
- en utilisant une source métallique pure à 99% au moins, comme par exemple une source d'or pur à 99% en poids.

Une telle couche conductrice de recouvrement 14 a pour effet de permettre une croissance homogène depuis toute la surface inférieure, si le substrat 10 est exempt de de couche conductrice de base 12, ou pour garantir une croissance homogène si la couche conductrice de base 12 est présente mais recouverte par endroits ou en totalité par des résidus. Lors de cette étape de dépôt physique en phase vapeur, qui est directionnel (selon la direction verticale de la figure 39), la présence des rebords 22 garantit l'absence de dépôt métallique sur les flancs ou les parois verticales des cavités 50. Ainsi, la couche conductrice de recouvrement 14 recouvre le fond des cavités 50 et la surface supérieure des parties activées 211 et pas les flancs verticaux, si bien que la croissance dans les cavités 50 lors d'une électrodéposition se fera de manière homogène à partir du fond des cavités 50, sans croissance parasite depuis les parois verticales.

### Application industrielle

Un procédé de fabrication de moule selon la présente invention, et l'utilisation de ces moules pour former des pièces métalliques, sont susceptibles d'application industrielle.

On comprendra que diverses modifications et/ou améliorations évidentes pour l'homme du métier peuvent être apportées aux différents modes de réalisation de l'invention décrits dans la présente description sans sortir de la portée des revendications.

## Revendications

1. Procédé de fabrication d'un moule pour former une pièce métallique par galvanoplastie et/ou croissance métallique, comprenant les étapes consistant à :
a- se munir d'un substrat (10) présentant une surface de base et de préférence une surface conductrice de base (12),
b- former au moins une couche d'accroche (131 ; 132 ; 133 ; 134 ; 135) sur la surface de base,
c- déposer au moins une couche de résine photosensible (21) sur la couche d'accroche (131 ; 132 ; 133 ; 134 ; 135),
d- irradier la couche de résine photosensible (21) au travers d'un masque,
e- développer la couche de résine photosensible (21) de sorte à creuser des cavités (50) dans la couche de résine photosensible (21) pour définir une empreinte de moulage,
dans lequel l'étape b- de formation de la couche d'accroche (134) comprend les étapes consistant à :
b20- déposer une couche d'accroche (134) de moins de 50 nm et de préférence de moins de 20 nm en silicium sur la surface de base,
et dans lequel le procédé comprend, de préférence après l'étape e- de développement de la couche de résine photosensible (21), au moins une étape consistant à rendre conductrice au moins une partie du fond des cavités (50).

2. Procédé de fabrication selon la revendication 1, le substrat comprenant la surface conductrice de base (12), dans lequel l'étape consistant à rendre conductrice au moins une partie du fond des cavités (50) comprend une gravure de la couche d'accroche (134) en silicium, par exemple une gravure ionique réactive, ou une gravure plasma CF₄/O₂ , ou une gravure plasma HF/O₂, ou une gravure plasma C₄F₈/O₂, ou une gravure chimique par voie humide par exemple avec une base comme de la soude ou de de l'hydroxyde de potassium, ou avec un acide comme de l'acide fluorhydrique.

3. Procédé de fabrication d'un moule pour former une pièce métallique par galvanoplastie et/ou croissance métallique, comprenant les étapes consistant à :
a- se munir d'un substrat (10) présentant une surface de base et de préférence une surface conductrice de base (12),
b- former au moins une couche d'accroche (131 ; 132 ; 133 ; 134 ; 135) sur la surface de base,
c- déposer au moins une couche de résine photosensible (21) sur la couche d'accroche (131 ; 132 ; 133 ; 134 ; 135),
d- irradier la couche de résine photosensible (21) au travers d'un masque,
e- développer la couche de résine photosensible (21) de sorte à creuser des cavités (50) dans la couche de résine photosensible (21) pour définir une empreinte de moulage,
dans lequel l'étape b- de formation de la couche d'accroche (135) comprend les étapes consistant à :
b30- déposer une couche d'accroche (135) d'oxyde métallique ou d'oxyde metalloïde,
b31- fonctionnaliser la couche d'accroche (135) d'oxyde métallique ou
d'oxyde metalloïde en déposant une couche de promotion adhésive préférentiellement organique comprenant par exemple une fonction capable de former une liaison avec la couche d'accroche (135) d'oxyde métallique ou
d'oxyde metalloïde, et plus préférentiellement comprenant une fonction silanol, phosphonate, thiol, amine, époxyde, acide carboxylique,
et dans lequel le procédé comprend, de préférence après l'étape e- de développement de la couche de résine photosensible (21), au moins une étape consistant à rendre conductrice au moins une partie du fond des cavités (50).

4. Procédé de fabrication d'un moule selon la revendication précédente, dans lequel l'étape b30- de dépose d'une couche d'accroche (135) d'oxyde métallique ou d'oxyde metalloïde est une étape de formation d'une couche d'accroche (135) en dioxyde de silicium SiO₂ ou en oxyde de métal, comme un oxyde de métal pauvre tel que de l'alumine Al₂O₃ ou un oxyde de métal de transition comme du dioxyde de titane TiO₂.

5. Procédé de fabrication d'un moule selon la revendication 3, dans lequel l'étape b30- de dépose d'une couche d'accroche (135) d'oxyde métallique ou d'oxyde metalloïde comprend :
- une étape consistant à déposer un métal ou un métalloïde par dépôt physique en phase vapeur comme de l'aluminium Al, du titane Ti, du silicium Si, et
- une étape consistant à oxyder ou à laisser s'oxyder à l'air le métal ou le métalloïde pour avoir en surface de l'oxyde métallique ou de l'oxyde metalloïde comme de l'alumine Al₂O₃, du dioxyde de titane TiO₂, du dioxyde de silicium SiO₂.

6. Procédé de fabrication d'un moule selon la revendication 3 ou 4, dans lequel l'étape consistant à rendre conductrice au moins une partie du fond des cavités (50) comprend une gravure de la couche d'accroche (135) en oxyde métallique ou en oxyde metalloïde, par exemple une gravure plasma, ou une gravure chimique par voie humide avec de la soude ou de de l'hydroxyde de potassium, ou avec un acide comme de l'acide fluorhydrique HF ou de l'acide fluorhydrique tamponné BHF.

7. Procédé de fabrication d'un moule selon la revendication 1 ou 3 ou 4, dans lequel l'étape consistant à rendre conductrice au moins une partie du fond des cavités (50) est une étape de formation d'une couche conductrice, par exemple en or, au fond des cavités (50) par dépôt physique en phase vapeur.

8. Procédé de fabrication selon la revendication 7, dans lequel l'étape de formation d'une couche conductrice au fond des cavités (50) formées à l'étape e- est ajustée pour :
- dépasser une limite de percolation de la couche conductrice déposée au fond des cavités (50) formées à l'étape e-, et
- ne pas dépasser la limite de percolation de la couche conductrice déposée sur les flancs des cavités (50) formées à l'étape e-.

9. Procédé de fabrication d'une pièce métallique par galvanoplastie et/ou croissance métallique (électrodéposition ou dépôt autocatalytique), comprenant :
- le procédé de fabrication d'un moule selon l'une des revendications 1 à 8,
- la formation d'une pièce métallique dans le moule par galvanoplastie et/ou croissance métallique.

10. Procédé de fabrication d'une pièce métallique selon la revendication 9, dans lequel la pièce métallique est une pièce horlogère.

## Patentansprüche

1. Verfahren zur Herstellung einer Form zum Bilden eines Metallteils durch Galvanoplastik und/oder metallisches Wachstum, umfassend die Schritte:
a- Bereitstellen eines Substrats (10), das eine Basisfläche und vorzugsweise eine leitfähige Basisfläche (12) aufweist,
b- Bilden mindestens einer Haftschicht (131; 132; 133; 134; 135) auf der Basisfläche,
c- Abscheiden mindestens einer Photolackschicht (21) auf der Haftschicht (131; 132; 133; 134; 135),
d- Bestrahlen der Photolackschicht (21) durch eine Maske,
e- Entwickeln der Photolackschicht (21), so dass in der Photolackschicht (21) Kavitäten (50) ausgehöhlt werden, um einen Formabdruck zu definieren,
wobei der Schritt b- des Bildens der Haftschicht (134) die Schritte umfasst:
b20- Abscheiden einer Haftschicht (134) aus Silizium mit weniger als 50 nm und vorzugsweise weniger als 20 nm auf der Basisfläche,
und wobei das Verfahren, vorzugsweise nach dem Schritt e- des Entwickelns der Photolackschicht (21), mindestens einen Schritt umfasst, der darin besteht, mindestens einen Teil des Bodens der Kavitäten (50) leitfähig zu machen.

2. Herstellungsverfahren nach Anspruch 1, wobei das Substrat die leitfähige Basisfläche (12) umfasst, wobei der Schritt, der darin besteht, mindestens einen Teil des Bodens der Kavitäten (50) leitfähig zu machen, ein Ätzen der Haftschicht (134) aus Silizium umfasst, zum Beispiel ein reaktives Ionenätzen, oder ein CF₄/O₂-Plasmaätzen, oder ein HF/O₂-Plasmaätzen, oder ein C₄F₈/O₂-Plasmaätzen, oder ein nasschemisches Ätzen zum Beispiel mit einer Base wie Natronlauge oder Kaliumhydroxid, oder mit einer Säure wie Flusssäure.

3. Verfahren zur Herstellung einer Form zum Bilden eines Metallteils durch Galvanoplastik und/oder metallisches Wachstum, umfassend die Schritte:
a- Bereitstellen eines Substrats (10), das eine Basisfläche und vorzugsweise eine leitfähige Basisfläche (12) aufweist,
b- Bilden mindestens einer Haftschicht (131; 132; 133; 134; 135) auf der Basisfläche,
c- Abscheiden mindestens einer Photolackschicht (21) auf der Haftschicht (131; 132; 133; 134; 135),
d- Bestrahlen der Photolackschicht (21) durch eine Maske,
e- Entwickeln der Photolackschicht (21), so dass in der Photolackschicht (21) Kavitäten (50) ausgehöhlt werden, um einen Formabdruck zu definieren,
wobei der Schritt b- des Bildens der Haftschicht (135) die Schritte umfasst:
b30- Abscheiden einer Haftschicht (135) aus Metalloxid oder Metalloidoxid,
b31- Funktionalisieren der Haftschicht (135) aus Metalloxid oder Metalloidoxid durch Abscheiden einer vorzugsweise organischen Haftvermittlungsschicht, die zum Beispiel eine Funktion umfasst, die in der Lage ist, eine Bindung mit der Haftschicht (135) aus Metalloxid oder Metalloidoxid zu bilden, und besonders bevorzugt eine Silanol-, Phosphonat-, Thiol-, Amin-, Epoxid-, Carbonsäure-Funktion umfasst,
und wobei das Verfahren, vorzugsweise nach dem Schritt e- des Entwickelns der Photolackschicht (21), mindestens einen Schritt umfasst, der darin besteht, mindestens einen Teil des Bodens der Kavitäten (50) leitfähig zu machen.

4. Verfahren zur Herstellung einer Form nach dem vorhergehenden Anspruch, wobei der Schritt b30- des Abscheidens einer Haftschicht (135) aus Metalloxid oder Metalloidoxid ein Schritt der Bildung einer Haftschicht (135) aus Siliziumdioxid SiO₂ oder aus Metalloxid ist, wie etwa einem armen Metalloxid wie Aluminiumoxid Al₂O₃ oder einem Übergangsmetalloxid wie Titandioxid TiO₂.

5. Verfahren zur Herstellung einer Form nach Anspruch 3, wobei der Schritt b30- des Abscheidens einer Haftschicht (135) aus Metalloxid oder Metalloidoxid umfasst:
- einen Schritt, der darin besteht, ein Metall oder ein Metalloid durch physikalische Gasphasenabscheidung abzuscheiden, wie etwa Aluminium Al, Titan Ti, Silizium Si, und
- einen Schritt, der darin besteht, das Metall oder das Metalloid an der Luft zu oxidieren oder oxidieren zu lassen, um an der Oberfläche Metalloxid oder Metalloidoxid wie Aluminiumoxid Al₂O₃, Titandioxid TiO₂, Siliziumdioxid SiO₂ zu erhalten.

6. Verfahren zur Herstellung einer Form nach Anspruch 3 oder 4, wobei der Schritt, der darin besteht, mindestens einen Teil des Bodens der Kavitäten (50) leitfähig zu machen, ein Ätzen der Haftschicht (135) aus Metalloxid oder Metalloidoxid umfasst, zum Beispiel ein Plasmaätzen, oder ein nasschemisches Ätzen mit Natronlauge oder Kaliumhydroxid, oder mit einer Säure wie Flusssäure HF oder gepufferter Flusssäure BHF.

7. Verfahren zur Herstellung einer Form nach Anspruch 1 oder 3 oder 4, wobei der Schritt, der darin besteht, mindestens einen Teil des Bodens der Kavitäten (50) leitfähig zu machen, ein Schritt zur Bildung einer leitfähigen Schicht, zum Beispiel aus Gold, am Boden der Kavitäten (50) durch physikalische Gasphasenabscheidung ist.

8. Herstellungsverfahren nach Anspruch 7, wobei der Schritt zur Bildung einer leitfähigen Schicht am Boden der in Schritt e- gebildeten Kavitäten (50) so eingestellt ist, dass er:
- eine Perkolationsgrenze der am Boden der in Schritt e- gebildeten Kavitäten (50) abgeschiedenen leitfähigen Schicht überschreitet, und
- die Perkolationsgrenze der an den Flanken der in Schritt e- gebildeten Kavitäten (50) abgeschiedenen leitfähigen Schicht nicht überschreitet.

9. Verfahren zur Herstellung eines Metallteils durch Galvanoplastik und/oder metallisches Wachstum (Elektroabscheidung oder autokatalytische Abscheidung), umfassend:
- das Verfahren zur Herstellung einer Form nach einem der Ansprüche 1 bis 8,
- das Bilden eines Metallteils in der Form durch Galvanoplastik und/oder metallisches Wachstum.

10. Verfahren zur Herstellung eines Metallteils nach Anspruch 9, wobei das Metallteil ein Uhrenteil ist.

## Claims

1. Method for manufacturing a mould for forming a metal part by electroforming and/or metallic growth, comprising the steps consisting of:
a- providing a substrate (10) having a base surface and preferably a base conductive surface (12),
b- forming at least one adhesion layer (131; 132; 133; 134; 135) on the base surface,
c- depositing at least one photosensitive resin layer (21) on the adhesion layer (131; 132; 133; 134; 135),
d- irradiating the photosensitive resin layer (21) through a mask,
e- developing the photosensitive resin layer (21) so as to hollow out cavities (50) in the photosensitive resin layer (21) to define a moulding impression,
wherein step b- of forming the adhesion layer (134) comprises the steps consisting of:
b20- depositing an adhesion layer (134) of less than 50 nm and preferably less than 20 nm of silicon on the base surface,
and wherein the method comprises, preferably after step e- of developing the photosensitive resin layer (21), at least one step consisting of making at least part of the bottom of the cavities (50) conductive.

2. Manufacturing method according to claim 1, the substrate comprising the base conductive surface (12), wherein the step consisting of making at least part of the bottom of the cavities (50) conductive comprises an etching of the silicon adhesion layer (134), for example a reactive ion etching, or a CF₄/O₂ plasma etching, or an HF/O₂ plasma etching, or a C₄F₈/O₂ plasma etching, or a wet chemical etching for example with a base such as sodium hydroxide or potassium hydroxide, or with an acid such as hydrofluoric acid.

3. Method for manufacturing a mould for forming a metal part by electroforming and/or metallic growth, comprising the steps consisting of:
a- providing a substrate (10) having a base surface and preferably a base conductive surface (12),
b- forming at least one adhesion layer (131; 132; 133; 134; 135) on the base surface,
c- depositing at least one photosensitive resin layer (21) on the adhesion layer (131; 132; 133; 134; 135),
d- irradiating the photosensitive resin layer (21) through a mask,
e- developing the photosensitive resin layer (21) so as to hollow out cavities (50) in the photosensitive resin layer (21) to define a moulding impression,
wherein step b- of forming the adhesion layer (135) comprises the steps consisting of:
b30- depositing an adhesion layer (135) of metal oxide or metalloid oxide,
b31- functionalising the metal oxide or metalloid oxide adhesion layer (135) by depositing an adhesion promotion layer preferentially organic comprising for example a function capable of forming a bond with the metal oxide or metalloid oxide adhesion layer (135), and more preferentially comprising a silanol, phosphonate, thiol, amine, epoxide, carboxylic acid function,
and wherein the method comprises, preferably after step e- of developing the photosensitive resin layer (21), at least one step consisting of making at least part of the bottom of the cavities (50) conductive.

4. Method for manufacturing a mould according to the preceding claim, wherein step b30- of depositing a metal oxide or metalloid oxide adhesion layer (135) is a step of forming an adhesion layer (135) of silicon dioxide SiO₂ or of metal oxide, such as a poor metal oxide such as alumina Al₂O₃ or a transition metal oxide such as titanium dioxide TiO₂.

5. Method for manufacturing a mould according to claim 3, wherein step b30- of depositing a metal oxide or metalloid oxide adhesion layer (135) comprises:
- a step consisting of depositing a metal or a metalloid by physical vapour deposition such as aluminium Al, titanium Ti, silicon Si, and
- a step consisting of oxidising or letting the metal or the metalloid oxidise in air to have on the surface metal oxide or metalloid oxide such as alumina Al₂O₃, titanium dioxide TiO₂, silicon dioxide SiO₂.

6. Method for manufacturing a mould according to claim 3 or 4, wherein the step consisting of making at least part of the bottom of the cavities (50) conductive comprises an etching of the metal oxide or metalloid oxide adhesion layer (135), for example a plasma etching, or a wet chemical etching with sodium hydroxide or potassium hydroxide, or with an acid such as hydrofluoric acid HF or buffered hydrofluoric acid BHF.

7. Method for manufacturing a mould according to claim 1 or 3 or 4, wherein the step consisting of making at least part of the bottom of the cavities (50) conductive is a step of forming a conductive layer, for example of gold, at the bottom of the cavities (50) by physical vapour deposition.

8. Manufacturing method according to claim 7, wherein the step of forming a conductive layer at the bottom of the cavities (50) formed in step e- is adjusted to:
- exceed a percolation limit of the conductive layer deposited at the bottom of the cavities (50) formed in step e-, and
- not exceed the percolation limit of the conductive layer deposited on the sides of the cavities (50) formed in step e-.

9. Method for manufacturing a metal part by electroforming and/or metallic growth (electrodeposition or autocatalytic deposition), comprising:
- the method for manufacturing a mould according to any one of claims 1 to 8,
- forming a metal part in the mould by electroforming and/or metallic growth.

10. Method for manufacturing a metal part according to claim 9, wherein the metal part is a horological part.
